## Europäisches Patentamt
## European Patent Office
## Office européen des brevets

(19)

(11) Numéro de publication: **0 035 425 B1**

# FASCICULE DE BREVET EUROPEEN

(12)

(45) Date de publication du fascicule du brevet: 25.04.84

(51) Int. Cl.³: **H 01 L 41/22**

(21) Numéro de dépôt: 81400239.0

(22) Date de dépôt: 17.02.81

(54) Procédé de fabrication de transducteurs électromécaniques utilisant au moins un film en polymère, et dispositif destiné à la mise en oeuvre de ce procédé.

(30) Priorité: 04.03.80 FR 8004832

(43) Date de publication de la demande: 09.09.81 Bulletin 81/36

(45) Mention de la délivrance du brevet: 25.04.84 Bulletin 84/17

(84) Etats contractants désignés: DE IT NL

(56) Documents cités:
EP - A - 0 002 161
FR - A - 2 151 047
US - A - 3 816 774

(73) Titulaire: THOMSON-CSF, 173, Boulevard Haussmann, F-75379 Paris Cedex 08 (FR)

(72) Inventeur: Facoetti, Hugues, THOMSON-CSF SCPI 173, bld Haussmann, F-75360 Paris Cedex 08 (FR)
Inventeur: Petit, Patrick, THOMSON-CSF SCPI 173, bld Haussmann, F-75360 Paris Cedex 08 (FR)
Inventeur: Menoret, Philippe, THOMSON-CSF SCPI 173, bld Haussmann, F-75360 Paris Cedex 08 (FR)
Inventeur: Micheron, François, THOMSON-CSF SCPI 173, bld Haussmann, F-75360 Paris Cedex 08 (FR)
Inventeur: Ravinet, Pierre, THOMSON-CSF SCPI 173, bld Haussmann, F-75360 Paris Cedex 08 (FR)

(74) Mandataire: Wang, Pierre et al, THOMSON-CSF SCPI 173, Bld Haussmann, F-75379 Paris Cedex 08 (FR)

Procédé de fabrication de transducteurs électromecaniques utilisant au moins un film en polymère
et dispositif destine a la mise en œuvre de ce procédé

L'invention se rapporte à la fabrication de transducteurs tels que microphone, écouteur, haut-parleur, sonde pour échographie, hydrophone, etc ... qui comportent au moins un élément actif comprenant un film de polymère muni d'électrodes. Le document US-A-3 816 774 décrit des transducteurs constitués d'une structure bimorphe comprenant deux films polymères adhérant l'un à l'autre. Cette structure est mise en forme par thermoformage entre deux moules équipés d'électrodes. Ces électrodes coopèrent avec des métallisations protées par la structure pour obtenir la polarisation électrique des films qui leur confère les propriétés piézo-électriques désirées. L'invention concerne plus particulièrement les transducteurs dans lesquels un ou plusieurs films de polymère sont mis en forme par thermoformage et/ou électroformage, afin de constituer une structure autoportante telle que dôme, cône, etc ... Ces formes correspondent à des surfaces non-développables que l'on obtient généralement à partir d'une structure simple ou composite dont les faces sont métallisées après la mise en forme. Dans le cas où la mise en forme engendre un étirement important du polymère, par exemple lorsqu'on met en forme un film plan pour obtenir une protubérance autoportante en forme de calotte sphérique, il s'établit une anisotropie mécanique telle que la forme obtenue peut avoir tendance à se recroqueviller au cours des opérations ultérieures de métallisation et de polarisation, lesquelles impliquent un échauffement du polymère. Pour pallier cet inconvénient, on est amené à utiliser plusieurs moules pour maintenir inchangée la forme obtenue dans toutes les étapes du procédé, ce qui complique le matériel de fabrication.

Lorsque la structure polymère mise en forme doit être munie d'électrodes sur chaque face qui délimitent des zones actives adjacentes, on rencontre des difficultés pour réaliser le masquage des zones entourant ces électrodes. En effet, la forme complexe de la structure fait que les motifs du masque sont projetés avec des déformations ou que, par suite de l'existence de zones d'ombre, le masquage introduit des discontinuités d'électrodes inacceptables.

En vue de pallier ces difficultés, l'invention propose de mettre en forme un film plan déjà revêtu de ses métallisations. La mise en forme réunit alors les actions combinées d'étirage, de chauffage et de polarisation électrique, alors que la pose préalable des métallisations sur la structure plane à mettre en forme simplifie la délimitation précise des électrodes. Pour qu'un tel procédé soit applicable, il faut que l'étirement des métallisations n'engendre aucune solution de continuité des électrodes et de leurs connexions et que les tensions résiduelles après mise en forme ne créent pas d'instabilité mécanique de la structure autoportante.

L'invention a pour objet un procédé de fabrication de transducteurs éléctromécaniques utilisant au moins un film en polymère auquel on fait subir une mise en forme telle que la structure obtenue soit autoportante et non développable, cette structure étant munie d'électrodes sur ses deux faces, ledit procédé consistant à munir préalablement les deux faces de la structure plane comportant ce film de métallisations semblables et à mettre en forme cette structure en appliquant au cours d'un processus thermique comportant une étape de chauffage suivie d'une étape de refroidissement, une contrainte mécanique sur les faces de la structure, et une tension de polarisation aux métallisations, ledit procédé étant caractérisé en ce que ladite contrainte mécanique consiste en un étirage des faces de la structure et résulte en une augmentation permanente de la surface des métallisations portées par cette structure, lesquelles sont destinées à former ces électrodes.

L'invention a également pour objet un dispositif destiné à la mise en œuvre de ce procédé de fabrication et comportant un poinçon associé à des moyens de pinçage périphérique de la structure en polymère délimitant à l'aplomb de ce poinçon la zone plane à mettre en forme, caractérisé en ce que la polarisation électrique de la structure en polymère est assurée par des connexions électriques établies au cours du formage entre les métallisations contenues dans cette zone plane, le poinçon et les moyens de pinçage périphérique.

L'invention sera mieux comprise au moyen de la description ci-après et des figures annexées parmi lesquelles:

— la figure 1 est une vue isométrique d'un appareillage permettant de mesurer la résistance électrique d'une métallisation soumise à étirage;

— les figures 2 et 3 sont des diagrammes explicatifs;

— la figure 4 représente en coupe méridienne un transducteur obtenu par le procédé selon l'invention;

— la figure 5 est une coupe de la structure à mettre en forme;

— la figure 6 est une vue en coupe partielle d'un dispositif de mise en forme selon l'invention;

— la figure 7 est une vue en coupe d'une variante de réalisation du poinçon de la figure 6;

— la figure 8 est une vue de profil d'une autre variante de réalisation du poinçon de la figure 6.

Le procédé de mise en forme selon l'invention s'applique à toute structure lamellaire comportant au moins un film de polymère encadré par deux dépôts métalliques. Un effet transducteur électromécanique linéaire et réversible peut être induit en créant dans le film de polymère une anisotropie électrique permanente. Cette anisotropie peut être obtenue par la création d'un excès de charge ou par orientation dipolaire des chaînes macromoléculaires en présence d'un champ électrique transverse de forte intensité. La technique de l'orientation dipolaire permet d'induire un effet piézoélectrique dans des homopolymères polaires tels que le polyfluorure de vinylidène (PVF$_2$), le polyfluorure de vinyle (PVF) et le polychlorure de vinyle (PVC) ainsi que dans des copolymères polaires tels que le copolymère de polyfluorure de de vinylidène et de polytétrafluorure d'éthylène (PVF$_2$ — PTFE).

La technique consistant à induire un excès de charge dans un polymère tel que le polytétrafluorure d'éthylène met en œuvre l'application à chaud d'un champ électrique intense. L'effet transducteur résulte alors des forces électrostatiques mises en jeu et de l'action linéarisante de l'excès de charge induit. On peut réaliser des structures bimorphes en faisant adhérer l'un à l'autre deux films de façon à obtenir une déformation par flexion.

Afin de simplifier la description qui va suivre, on considère à titre d'exemple non limitatif le cas d'une structure comportant un film de polymère polaire tel que le PVF$_2$ dont les deux faces ont reçu une métallisation par évaporation thermique.

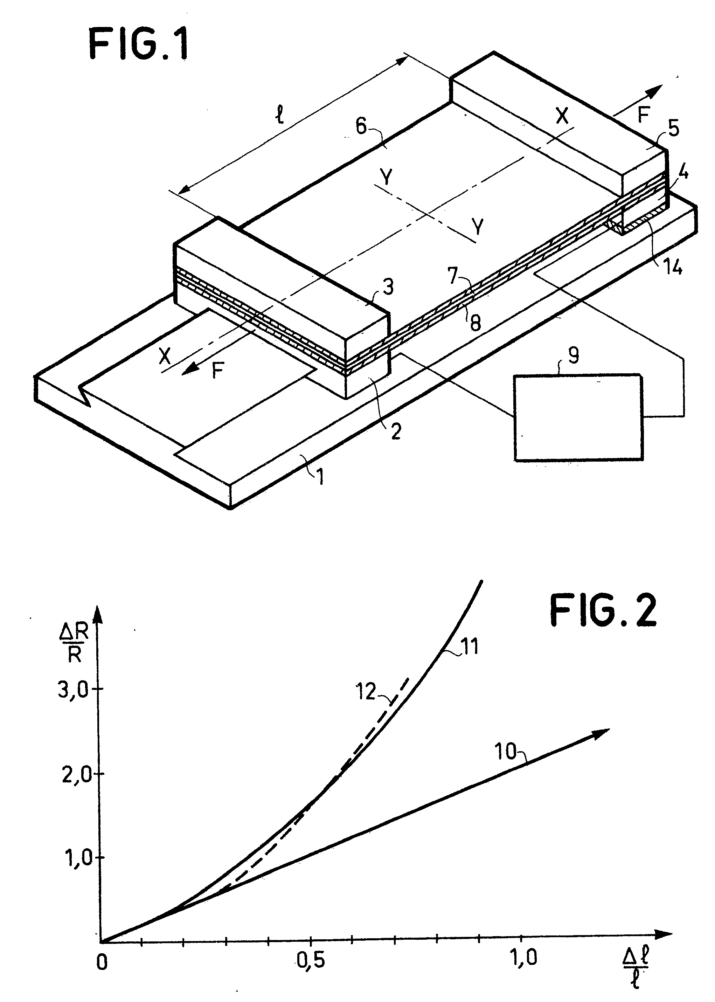

L'appareillage illustré par la figure 1 sert à étirer un film de polymère métallisé sur ses deux faces pour mettre en évidence l'aptitude des métallisations à conserver leurs qualités conductrices et leur adhérence lors d'une déformation plastique importante. L'appareillage de la figure 1 comprend un banc prismatique 1 d'axe XX portant un support fixe 4 isolé électriquement par une semelle 14. Un support mobile 2 coulisse le long du banc 1. Deux plaques de serrage 3 et 5 coopèrent avec les supports 2 et 4, afin de pincer énergiquement les extrémités d'une éprouvette de traction de forme rectangulaire. Celle-ci est constituée par un film de matériau polymère 7 aux faces duquel adhèrent des métallisations 6 et 8 similaires. Un ohmmètre 9 est branché entre les masses conductrices 2 et 4 de façon à mesurer la résistance électrique de la métallisation 8.

Au début de l'essai de traction, la structure 6, 7, 8 est simplement tendue et l'ohmmètre 9 fournit la mesure R de la résistance initiale de la couche 8 entre deux lignes de contact parallèles distantes de 1. On applique alors aux supports 2 et 4 des forces d'écartement F de façon à créer un allongement $\Delta l$ auquel correspond un accroissement $\Delta R$ de la résistance mesurée. En faisant croître par valeurs discrètes l'allongement $\Delta l$, on note les accroissements correspondants $\Delta R$ de la résistance électrique de la métallisation 8.

Sur la figure 2, on a reporté sur un diagramme les allongements relatifs $\dfrac{\Delta l}{l}$ et les accroissements de résistance relatifs $\dfrac{\Delta R}{R}$ pour deux compositions différentes des couches métalliques 6 et 8. La courbe 11 relie la variation de résistance $\dfrac{\Delta R}{R}$ à l'allongement relatif $\dfrac{\Delta l}{l}$ dans le cas de métallisations constituées par l'évaporation sur chaque face du film 7 d'une couche de chrome de 30 Å suivie de l'évaporation d'une couche d'or de 500 à 600 Å. La courbe 12 en pointillé se rapporte au cas de métallisations constituées sur chaque face du film 7 par l'évaporation thermique d'une couche d'aluminium de 1500 Å d'épaisseur.

On voit que pour des allongements relatifs faibles, la pente des courbes 11 et 12 suit la droite 10 passant par les points

$$\left(\frac{\Delta l}{l} = 0, \ \frac{\Delta R}{R} = 0\right)$$

et

$$\left(\frac{\Delta l}{l} = 0,5, \ \frac{\Delta R}{R} = 1\right)$$

Dans cette plage d'étirement, on peut considérer que la variation de résistance de la métallisation résulte de la striction réversible de la section de passage du courant de mesure et de l'allongement élastique du trajet emprunté par ce courant. Pour des allongements proportionnels plus importants les courbes 11 et 12 se séparent de la droite 10 en s'incurvant vers le haut ce qui indique une croissance plus rapide de $\dfrac{\Delta R}{R}$ en fonction de $\dfrac{\Delta l}{l}$. Cette croissance plus rapide peut s'expliquer par l'augmentation de résistivité $\varrho$ qui caractérise le comportement des films minces et par la formation de micro-fissures entre les grains élémentaires constituant la couche métallique.

Dans l'expérience que vient d'être décrite, le film 7 a une épaisseur de 25 μm et l'ensemble de l'appareillage est placé dans une enceinte thermostatique portée à la température de 100°C. Cette température est celle à laquelle on effectue habituellement la mise en forme du PVF$_2$. Ce qui est remarquable, c'est que l'essai de traction peut se poursuivre au-delà d'un allongement relatif de 100% sans que soit observée une interruption brusque du courant de mesure. D'autre part l'adhérence des métallisations reste bonne et la structure étirée conserve sa forme après déchargement.

L'essai de traction dont les résultats sont donnés à la figure 2 se rapporte à un étirement undirectionnel selon l'axe XX. Pour juger des possibilités de mise en forme dans le cas où l'étirement est biaxial, on a réalisé en deux temps l'étirement de la structure de la figure 1 d'abord suivant l'axe XX et ensuite suivant l'axe YY. Entre les deux essais de traction, la structure 6, 7, 8 a été démontée et reserrée après une rotation de 90° dans son plan.

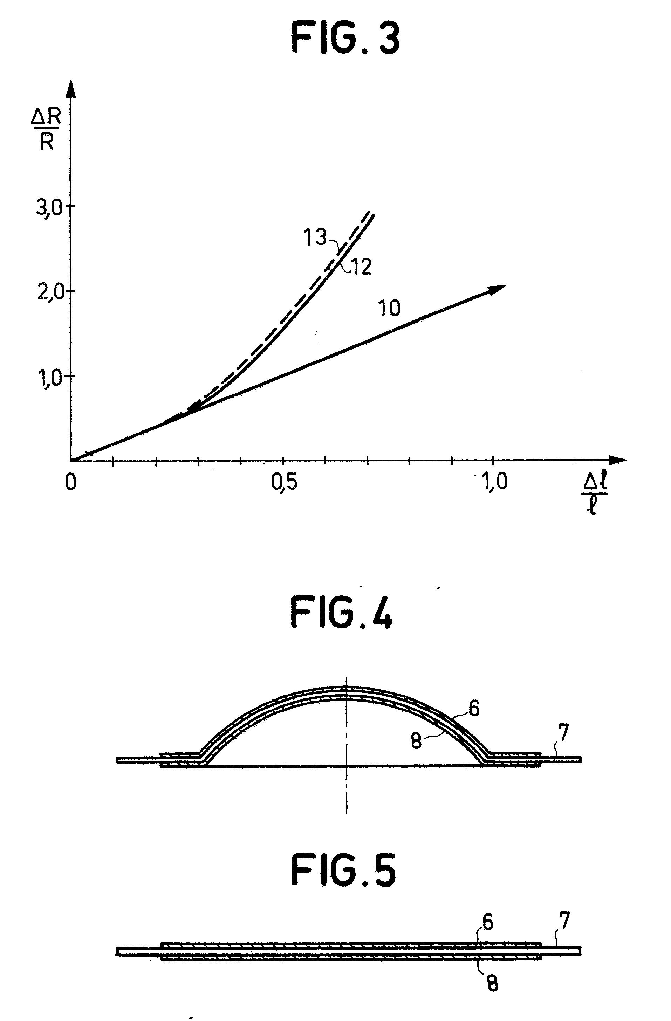

La figure 3 représente à la même échelle qu'à la figure 2 la loi de variation de l'accroissement relatif de résistance $\frac{\Delta R}{R}$ en fonction de l'allongement proportionnel $\frac{\Delta l}{l}$. La courbe 12 correspond au premier étirement selon la direction XX et la courbe pointillée 13 se rapporte au deuxième essai de traction suivant l'axe YY. Ces courbes sont superposables aux erreurs expérimentales près. On peut en déduire qu'une mise en forme comportant un étirement biaxial peut être envisagé dans une gamme d'allongements proportionnels très étendue. L'élévation de la résistance électrique reste modéré et est sans conséquence dans le cadre de systèmes transducteurs mettant en œuvre des champs électriques induits dans des matériaux diélectriques.

La figure 4 représente un élément transducteur piézoélectrique en forme de calotte sphérique qui comporte un film mince de polymère 7 muni des métallisations 6 et 8. La figure 5 montre la structure de laquelle on est parti pour mettre en forme l'élément transducteur de la figure 4. Pour éviter une disrupture électrique par contournement, le disque diélectrique 7 déborde les métallisations 6 et 8. En effet, lors de la mise en forme, on soumet le film de polymère à un champ électrique de polarisation dont l'intensité est de l'ordre de 1 MV/cm. La tension à appliquer entre les métallisations 6 et 8 peut atteindre plusieurs milliers de volts pour une interdistance de seulement 25 μm. Dans le cas de la figure 4, la hauteur de la calotte sphérique est de 15 mm pour un diamètre à la base de 70 mm. Les métallisations planes de la figure 5 ont un diamètre légèrement supérieur pour permettre le pinçage périphérique avec prise de contact. L'étirement biaxial moyen est dans ce cas voisin de 11%, c'est-à-dire bien moindre que celui que peuvent supporter les métallisations avant rupture ou décollement.

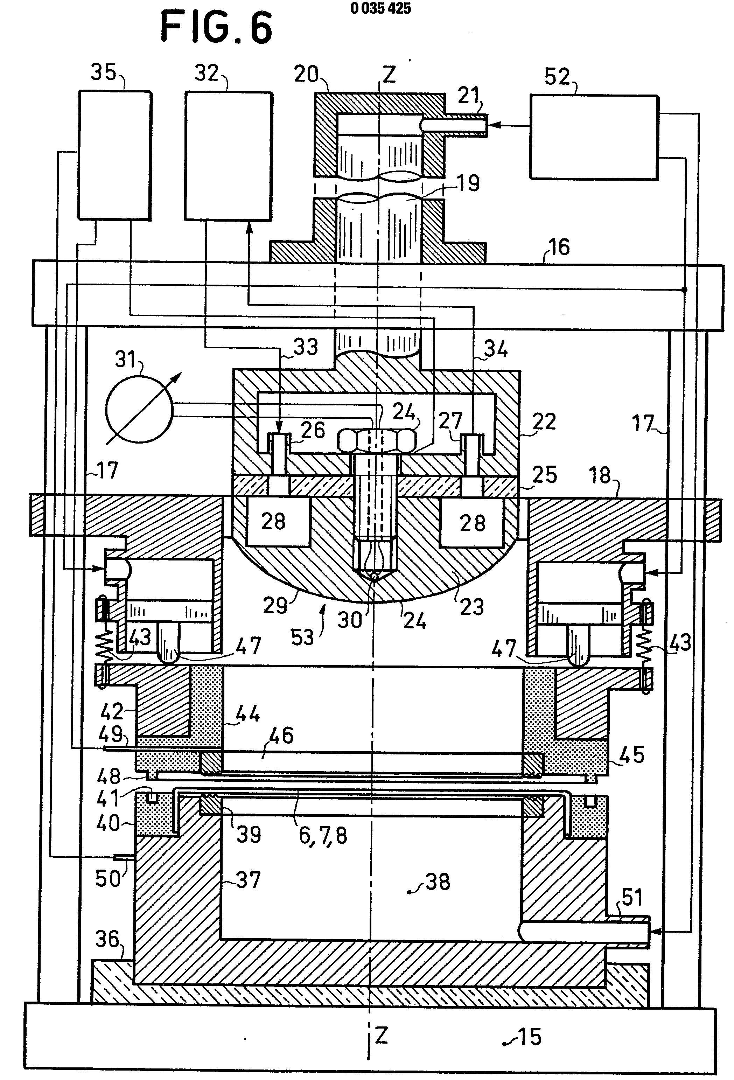

Pour mettre en forme l'élément représenté sur la figure 5, on peut se servir du dispositif dont la figure 6 représente une coupe partielle.

Ce dispositif comporte un socle 15 relié à un tablier supérieur 16 par des colonnes 17. Une couronne coulissante 18 peut être bloquée sur les colonnes 17 à une hauteur convenable du socle 15. Le tablier supérieur 16 comporte un alésage central dans lequel passe le piston 19 d'un vérin hydraulique 20 muni d'une tubulure d'admission 21. L'extrémité inférieure du piston 19 se présente sous la forme d'un corps cylindrique creux 22 à la face inférieure duquel est monté un poinçon 23. Le poinçon 23 est fixé au corps creux 22 par un boulon 24 comportant un alésage central. Le poinçon 23 est isolé thermiquement du corps creux 22 par un joint 25 et pour éviter un pont thermique, le boulon 24 est réalisé en polytétrafluorure d'éthylène. La face inférieure du corps creux 22 est munie de deux embouts 26 et 27 qui communiquent avec une chambre annulaire 28 par l'intermédiaire de deux trous pratiqués dans le joint thermique 25. Le poinçon 23 est réalisé en métal bon conducteur de la chaleur et sa face inférieure polie 29 épouse la forme non développable que l'on désire imposer à la structure plane 6, 7, 8. Un thermocouple 30 sert à mesurer la température du poinçon 23; il est relié à un millivoltmètre 31 par des connexions électriques passant par l'alésage central du boulon 24. L'échauffement du poinçon 23 est obtenu par exemple par le circulation d'un fluide caloporteur tel que l'air chaud dans la chambre annulaire 28. A cet effet, une source de chaleur 32 est reliée par des canalisations 33 et 34 aux embouts 26 et 27. On peut faire circuler en alternance de l'air chaud ou froid selon que l'on veut échauffer ou refroidir le poinçon 23. Une connexion électrique non représentée sur la figure 6 existe entre le corps 22 et le poinçon 23. Un générateur de tension de polarisation 35 a sa borne de masse reliée au corps creux 20 et par conséquent au poinçon 23.

Les moyens de pinçage périphérique de la structure 6, 7, 8 à mettre en forme comportent une semelle isolante 36 qui repose sur le socle 15. La semelle 36 porte un pot métallique 37 à paroi latérale cylindrique qui renferme une cavité 38 suiffisamment profonde pour recevoir la partie active inférieure du ponçon 23. Le rebord intérieur de la paroi latérale du pot 37 est muni d'un anneau métallique 39 dont la face supérieure est usinée de façon à présenter plusieurs gorges concentriques à profil rectangulaire. A titre d'exemple non limitatif, les gorges de l'anneau 39 ont un pas de 0,5 mm, une largeur de 0,3 mm et une profondeur de 0,2 mm. Le rebord extérieur de la paroi cylindrique de pot 37 a subi une dépouille dans laquelle prend place un anneau de retenue 40 de la structure 6, 7, 8. Cet anneau de retenue 40 est réalisé en matière isolante et sert au maintien des bords rabattus de la structure 6, 7, 8. La face supérieure de l'anneau 40 comporte une rainure circulaire de centrage 41. Au dessus du pot 37 une couronne de pinçage 42 est prévue. Cette couronne 42 est en rappel vers la couronne 18 grâce à des ressorts 43. Elle est garnie intérieurement d'une chemise isolante 44 qui présente un rebord 45 recouvrant complétement la face inférieure de la couronne 42. Le rebord intérieur de la chemise 44 est muni d'un anneau conducteur 46 de même type que l'anneau 39. Les anneaux striés 46 et 39 font office de mors de serrage et de prise de connexion pour les métallisations 8 et 6 de la structure à mettre en forme. Le pinçage de la structure à mettre en forme résulte de la poussée exercée par des vérins 47 logés sur la couronne 18. Ces vérins 47 tendent à rapprocher la couronne 42 du pot 37. Le centrage est assuré par un bossage circulaire 48 qui s'engage dans la rainure circulaire 41. L'anneau 46 est relié électriquement au générateur 35 par une connexion électrique 49. L'anneau 39 est relié électriquement au générateur 35 par une connexion électrique 50, via le pot métallique 37.

Il est prévu de soumettre la cavité 38 et la face inférieure de la structure à mettre en forme à une contre pression hydrostatique. A cet effet. Le pot 37 est muni d'un embout 51. Un générateur 52 de fluides sous pression alimente par des canalisations appropriées les embouts 51, 21 et les vérins 47. La couronne 18, la cehemise 44 et la cavité 38 forment un puit dans lequel le poinçon peut descendre suffisamment bas pour mettre complétement en forme la structure 6, 7, 8.

Pour illustrer le fonctionnement du dispositif de la figure 6, on va pour commencer décrire le formage par poinçonnage d'une calotte sphérique ayant par exemple un demi angle d'ouverture de 45°. Au début de l'opération, le poinçon 23 est remonté ainsi que la couronne 18. Le poinçon 23 est porté à la température désirée pour le formage, par exemple 100°C. L'échauffement résulte de la circulation du fluide caloporteur (air, eau, glycol, etc...) entre la chambre annulaire 28 et la source 32. La température est contrôlé par le thermocouple 30 et le millivoltomètre 31. La couronne 42 étant relevée, on accède facilement au pot 37. Après avoir enlevé l'anneau de maintien 40, on centre sur l'anneau 39 une structure plane telle que représentée sur la figure 5 et on replie ses bords en replaçant l'anneau 40. L'orifice 51 est ouvert à l'air libre. On peut abaisser la couronne 18 et la bloquer sur les colonnes 17. En faisant fonctionner les vérins 47, on provoque un pinçage énergique de la structure 6, 7, 8 entre les mors 39 et 46 ce qui établit les connexions électriques avec les métallisations 8 et 6. En agissant au moyen d'un vérin 20, on abaisse le poinçon 23 jusqu'au contact avec la métallisation 8 du film 7. Ainsi, le film 7 s'échauffe grâce à la chaleur cédée par le poinçon. Lorsque l'équilibre thermique est atteint la tension de polarisation est appliquée à la connexion 50 et l'on entame le formage par une descente lente du poinçon 23. A titre d'exemple non limitatif, la descente est de 2 mm/min. Cette descente est interrompue lorsque le poinçon épouse par sa face bombée toute l'étendue de la structure à former. La tension de polarisation est maintenue environ 20 minutes et ayant de la couper, on refroidit le poinçon pour ramener la structure thermoformée à la température ambiante. Il ne reste plus qu'à remonter le poinçon et à libérer la structure thermoformée en supprimant le pinçage périphérique et en enlevant l'anneau de maintien 40. La mise en forme résulte du thermoformage par le poinçon et de l'électroformage provenant de la tension de polarisation.

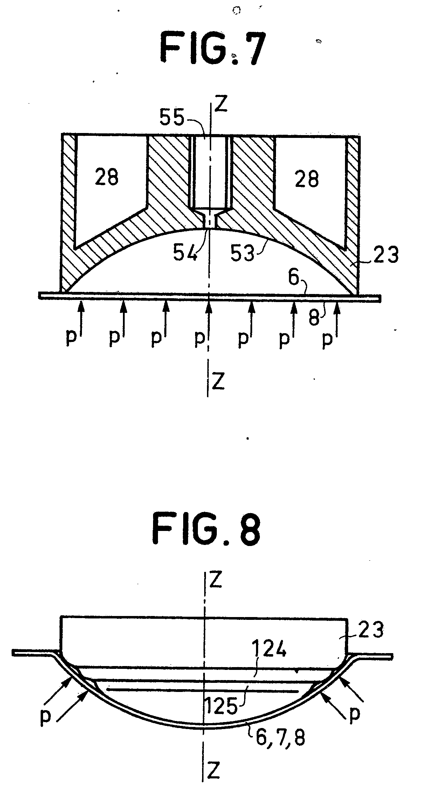

Sur la figure 7, on peut voir une vue en coupe d'un poinçon 23 permettant de réaliser le formage de la structure sous l'action de la poussée hydrostatique p. La face inférieure 53 du poinçon 23 est concave et le pôle est occupé par un minuscule orifice 54 qui permet à l'air enfermé entre le film à mettre en forme et la face concave 53 de s'échapper. Le fonctionnement est le même que précédemment jusqu'à contact du poinçon et de la métallisation 6. A ce moment on fait agir dans la cavité 38 une pression hydrostatique fournie par la source 52. Le fluide utilisé peut être liquide ou gazeux, son rôle étant de faire épouser à la structure de la figure 5 la forme concave de la face 53.

L'échauffement du film est encore assuré par un fluide caloporteur circulant dans la chambre annulaire 28 du poinçon, mais il est également possible de placer une source de chaleur rayonnante dans la cavité 38.

Lorsque la température de formage est atteinte, le champ de polarisation est appliqué et le fluide de formage est injecté par l'embout 51 sous une pression pouvant atteindre quelques centaines de milliers de Pascal. Après le temps de chauffage de vingt minutes, le film est refroidi sous champ électrique et la poussée p peut être réduite à zéro.

Une variante de ce procédé consiste à laisser communiquer l'orifice 51 à l'air libre et à aspirer par l'orifice 55 l'air emprisonné entre le film et la face 53. La poussée p est limitée à la valeur de 100 000 Pascal, ce qui suffit pour former le dôme décrit à la figure 4.

Les deux modes d'action précédemment décrits peuvent se combiner lorsque la forme désirée est faite de parties convexes et concaves.

Ce cas se présente notamment lorsqu'on fabrique un dôme muni d'indulations circonférentielles. La forme d'un poinçon approprié est illustrée par la figure 8 qui montre deux dépressions périphériques 124 et 125. La forme générale est acquise par poinçonnage. Après cet enfoncement, le film est amené à épouser la forme des parties concaves 124 et 125 sous l'action d'une poussée hydrostatique exercée dans la cavité 38 par un fluide liquide ou gazeux.

Dans les modes de formage qui précèdent le poinçon 23 est alternativement chauffé et refroidi, ce qui allonge le temps de fabrication.

On peut également obtenir de bons résultats en maintenant le poinçon à température constante. A cette fin, la métallisation supérieure de la structure à thermoformer est reliée à la masse du générateur 35 par une connexion 49 qui permet d'appliquer la tension de polarisation au film de polymère indépendamment du fait que le poinçon soit en contact avec la structure à mettre en forme. Lorsque le formage est terminé, on met en dépression la cavité 38 et on remonte le poinçon ce qui assure le refroidissement sous champ électrique. La forme acquise se conserve grâce à la dépression et la séparation film poinçon est facilitée. Cette séparation n'entraine aucune coupure du champ électrique de polarisation pendant le refroidissement de la structure mise en forme.

La préparation de la structure de la figure 5 en vue de la mise en forme consiste à former des métallisations sur chaque face d'un film de polymère. Ces métallisations peuvent être obtenues par évaporation thermique sous vide en deux temps. Les conditions de température sont différentes, car le second dépôt se fait en présence du premier qui se comporte comme un miroir. Il en résulte que les propriétés de formage ne sont pas exactement les mêmes pour les deux faces du film polymère.

On a constaté en pratique que les défauts d'aspect de la structure mise en forme sont absents lorsqu'on s'arrange pour tourner vers le poinçon la métallisation qui a été réalisée en second.

Pour rendre la fabrication plus rationnelle, on peut utiliser une bande de film polymère introduite entre les mors 39 et 46. Lors de la descente du poinçon, le serrage des mors et la découpe de la structure interviennent sans qu'il soit nécessaire de prédécouper les structures planes et de les maintenir une par une au moyen de l'anneau 40. Avant de pénétrer entre les mors 39 et 46 la bande a reçu par masquage des métallisations qui se suivent à pas constant. Chaque structure mise en forme peut conserver avec la bande des points de liaison qui facilitent son déchargement et qui sont ultérieurement rompus. Moyennement de telles adaptations, la fabrication en continu et automatisée peut être envisagée. Les moyens de chauffage de la structure peuvent être renforcés ou remplacés en prévoyant par exemple de noyer des résistances chauffantes dans la paroi du pot 37 ou du poinçon 23. On peut aussi faire circuler un fluide caloporteur dans la masse du pot 37. Dans le cas de la méthode par poinçonnage, on peut remplir la cavité 38 au moyen d'un liquide caloporteur ou réchauffé par un autre fluide. Ce liquide de remplissage peut éventuellement établir une connexion électrique avec la structure s'il est rendu conducteur.

## Revendications

1. Procédé de fabrication de transducteurs électromécaniques utilisant au moins un film en polymère (7) auquel on fait subir une mise en forme telle que la structure obtenue soit autoportante et non développable, cette structure étant munie d'électrodes (6, 8) sur ses deux faces, ledit procédé consistant à munir préalablement les deux faces de la structure plane comportant ce film (7) de métallisations (6, 8) semblables et à mettre en forme cette structure en appliquant au cours d'un processus thermique comportant une étape de chauffage suivie d'une étape de refroidissement, une contrainte mécanique sur les faces de la structure, et une tension de polarisation aux métallisations, ledit procédé étant caractérisé en ce que ladite contrainte mécanique consiste en un étirage des faces de la structure et résulte en une augmentation permanente de la surface des métallisations portées par cette structure, lesquelles sont destinées à former ces électrodes (6, 8).

2. Procédé selon la revendication 1, caractérisé en ce que ladite structure est pincée sur son pourtour par un cadre rigide (39, 45) muni de mors, ladite contrainte mécanique résultant de l'enfoncement des parties non pincées de ladite structure par un corps solide (23) portant l'empreinte (53) de la forme à réaliser.

3. Procédé selon la revendication 1, caractérisé en ce que la structure est placée au-dessus d'une cavité (38) située sous l'une de ses faces; une poussée hydrostatique (p) produite par un fluide contenu dans cette cavité assurant le placage de la structure contre une empreinte (53) portée par un corps solide (23) situé sur l'autre face de la structure.

4. Procédé selon la revendication 3, caractérisé en ce que le fluide contenu dans la cavité (38) est à la pression atmosphérique; le placage ayant lieu sous l'action d'une dépression exercée sur la face en vis-à-vis de l'empreinte (53).

5. Procédé selon l'une quelconque des revendications 2 à 4, caractérisé en ce qu'après sa mise en forme la structure est séparée de l'empreinte à l'aide d'un moyen d'aspiration.

6. Procédé selon l'une quelconque des revendications 2 à 5, caractérisé en ce que la structure plane à mettre en forme est métallisée par évaporation thermique sous vide d'abord selon sa première face et ensuite selon son autre face; cette autre face étant tournée vers l'empreinte du corps solide (23) servant à la mise en forme.

7. Dispositif destiné à la mise en oeuvre du procédé de fabrication selon l'une quelconque des revendications 1 à 6, comprenant un poinçon (23) associé à des moyens de pinçage périphérique (39, 46) de la structure en polymère délimitant à l'aplomb de ce poinçon la zone plane à mettre en forme, caractérisé en ce que la polarisation électrique de la structure en polymère est assurée par des connexions électriques établies au cours du formage entre les métallisations (6, 8) contenues dans cette zone plane, le poinçon (23) et les moyens de pinçage périphérique (39, 46).

8. Dispositif selon la revendication 7, caractérisé en ce que les moyens de pinçage périphérique sont solidaires d'un pot (37) et d'une couronne (42); le pot (37) comportant une cavité (38) permettant de créer sur l'une des faces de la structure à mettre en forme une contre-pression hydrostatique créée par adduction ou extraction d'un fluide.

9. Dispositif selon l'une quelconque des revendications 7 et 8, caractérisé en ce que des moyens échangeurs de chaleur (32) sont prévus pour échauffer et refroidir la structure faisant l'objet de la mise en forme.

10. Dispositif selon la revendication 9, caractérisé en ce que ces moyens comprennent un générateur de fluide caloporteur (32) raccordé à une chambre de circulation (28) située à l'intérieur du poinçon.

11. Dispositif selon l'une quelconque des revendications 7 à 10, caractérisé en ce que la face du poinçon (23) déterminant la mise en forme est convexe.

12. Dispositif selon l'une quelconque des revendications 7 à 10, caractérisé en ce que la face du poinçon (23) déterminant la mise en forme est concave.

13. Dispositif selon l'une quelconque des revendications 7 à 10, caractérisé en ce que la face du poinçon (23) déterminant la mise en forme est composée de parties convexe et concave.

14. Dispositif selon l'une quelconque des revendications 7 à 13, caractérisé en ce que la commande de déplacement du poinçon (23) et celle des moyens de pinçage périphérique (39, 46) est une commande par vérin (20, 47).

## Patentansprüche

1. Verfahren zur Herstellung von elektromechanischen Wandlern, bei denen wenigstens ein Polymerfilm (7) verwendet wird, dem eine solche Gestalt verliehen wurde, daß die erhaltene Struktur selbsttragend und nicht abwickelbar ist, wobei diese Struktur mit Elektroden (6, 8) auf den beiden Flächen versehen ist, und wobei dieses Verfahren darin besteht, daß zuvor die zwei Flächen der ebenen Struktur, die diesen Film (7) enthält, mit gleichen Metallisierungen (6, 8) versehen werden und diese Struktur geformt wird, indem im Verlauf eines thermischen Prozesses, der eine Erwärmungsstufe mit einer anschließenden Abkühlstufe enthält, eine mechanische Spannung auf den Flächen der Struktur sowie eine Polarisationsspannung an den Metallisierungen erzeugt werden, wobei dieses Verfahren dadurch gekennzeichnet ist, daß die genannte Spannung in einer Streckung der Flächen der Struktur besteht und zu einer dauerhaften Vergrößerung der Oberfläche der von dieser Struktur getragenen Metallisierungen führt, welche dazu bestimmt sind, die Elektroden (6, 8) zu bilden.

2. Verfahren nach Anspruch 1, dadurch gekennzeichnet, daß die genannte Struktur an ihrem Umfang durch einen starren Rahmen (39, 45) eingeklemmt ist, der mit Klemmteilen versehen ist, wobei die genannte mechanische Spannung durch Eindrücken der nicht eingeklemmten Teile der genannten Struktur mittels eines festen Körpers (23) erhalten ist, welcher die Matrize (53) der herzustellenden Form trägt.

3. Verfahren nach Anspruch 1, dadurch gekennzeichnet, daß die Struktur über einen Hohlraum (38) gelegt wird, der unter einer ihrer Flächen liegt; wobei ein hydrostatischer Druck (p), der durch ein in diesem Hohlraum enthaltenes fluides Medium erzeugt wird, das Anlegen der Struktur gegen eine Matrize (53) gewährleistet, die ein fester Körper (23) trägt, welcher sich auf der anderen Seite der Struktur befindet.

4. Verfahren nach Anspruch 3, dadurch gekennzeichnet, daß das in dem Hohlraum (38) enthaltene fluide Medium unter Atmosphärendruck steht; wobei das Anlegen unter der Wirkung eines Unterdrucks erfolgt, der auf die der Matrize (53) zugewandte Fläche ausgeübt wird.

5. Verfahren nach einem der Ansprüche 2 bis 4, dadurch gekennzeichnet, daß die Struktur, nachdem sie in Form gebracht worden ist, von der Matrize mittels einer Ansaugeinrichtung abgetrennt wird.

6. Verfahren nach einem der Ansprüche 2 bis 5, dadurch gekennzeichnet, daß die ebene, in Form zu bringende Struktur durch thermisches Verdampfen unter Vakuum zunächst auf ihrer ersten und anschließend auf ihrer anderen Fläche metallisiert wird; wobei diese andere Fläche der Matrize des festen Körpers (23) zugewendet ist, die zum Formen verwendet wird.

7. Vorrichtung zur Durchführung des Verfahrens nach einem der Ansprüche 1 bis 6, mit einem Stempel (23), der Mitteln (39, 46) zum Einklemmen der Polymerstruktur an ihrem Umfang zugeordnet ist, welche in der Senkrechten dieses Stempels die ebene, zu formende Zone begrenzen, dadurch gekennzeichnet, daß die elektrische Polarisierung der Polymerstruktur durch elektrische Anschlüsse gewährleistet wird, die im Verlauf des Formens zwischen den in dieser ebenen Zone enthaltenen Metallisierungen (6, 8), dem Stempel (23) und den Umfangs-Klemmitteln (39, 46) hergestellt werden.

8. Vorrichtung nach Anspruch 7, dadurch gekennzeichnet, daß die Umfangs-Klemmittel fest verbunden sind mit einem Topf (37) und einem Kranz (42); wobei der Topf (37) einen Hohlraum (38) aufweist, der es ermöglicht, auf einer der Flächen der zu formenden Struktur einen hydrostatischen Gegendruck zu erzeugen, welcher durch Einleitung oder Absaugen eines fluiden Mediums erzeugt wird.

9. Vorrichtung nach Anspruch 7 oder 8, dadurch gekennzeichnet, daß Wärmetauschermittel (32) vorgesehen sind, um die Struktur, welche Gegenstand der Formgebung ist, zu erwärmen und abzukühlen.

10. Vorrichtung nach Anspruch 9, dadurch gekennzeichnet, daß diese Mittel einen Wärmeträgerfluid-Generator (32) enthalten, der an eine Zirkulationskammer (28) angeschlossen ist, welche sich im Inneren des Stempels befindet.

11. Vorrichtung nach einem der Ansprüche 7 bis 10, dadurch gekennzeichnet, daß die Fläche des Stempels (23), durch welche die Formgebung bestimmt wird, konvex ist.

12. Vorrichtung nach einem der Ansprüche 7 bis 10, dadurch gekennzeichnet, daß die Fläche des Stempels (23), durch welche die Formgebung bestimmt wird, konkav ist.

13. Vorrichtung nach einem der Ansprüche 7 bis 10, dadurch gekennzeichnet, daß die Fläche des Stempels (23), welche die Formgebung bestimmt, aus konvexen und konkaven Teilen zusammengesetzt ist.

14. Vorrichtung nach einem der Ansprüche 7 bis 13, dadurch gekennzeichnet, daß die Steuerung der Bewegung des Stempels (23) sowie die der Umfangs-Klemmittel (39, 46) eine Steuerung durch einen Arbeitszylinder (20, 47) ist.

## Claims

1. Method of fabricating electromechanical transducers employing at least one polymer film (7) which is subjected to a shaping such that the structure obtained is self-supporting and non-developable, said structure being equipped with electrodes (6, 8) on its two faces, said method consisting in previously providing the two faces of the plane structure comprising said film (7) with identical metallizations (6, 8) and shaping said structure by applying in the course of a thermal process comprising a heating stage followed by a cooling stage a mechanical stress to the faces of the structure and a polarization voltage to the metallizations, said method being characterized in that said mechanical stress consists in a stretching of the faces of the structure and results in a permanent increase in the area of the metallizations carried by said structure and intended to form the electrodes (6, 8).

2. Method according to claim 1, characterized in that said structure is clamped at its periphery by a rigid frame (39, 45) equipped with clamping members, said mechanical stress resulting from the depression of the unclamped portions of said structure by means of a solid body (23) which carries the die (53) of the form to be produced.

3. Method according to claim 1, characterized in that the structure is placed above a cavity (38) situated below one of the faces thereof; a hydrostatic pressure (p) produced by a fluid contained in said cavity ensuring the application of the structure against a die (53) carried by a solid body (23) situated on the other face of the structure.

4. Method according to claim 3, characterized in that the fluid contained in the cavity (38) is under atmospheric pressure; the application taking place under the action of a reduced pressure applied to the face facing the die (53).

5. Method according to any one of claims 2 to 4, characterized in that the structure after being brought into shape is separated from the die with the aid of a suction means.

6. Method according to any one of claims 2 to 5, characterized in that the plane structure to be shaped is metallized by thermal evaporation under vacuum firstly on its first and then on its other face; this other face is turned towards the die of the solid body (23) used for the shaping.

7. Device intended for the execution of the fabrication method according to any one of claims 1 to 6, comprising a die (23) associated with means (39, 46) for peripheral clamping of the polymer structure delimiting in the vertical of said die the plane zone to be formed, characterized in that the electrical polarization of the polymer structure is ensured by electrical connections established in the course of the forming between the metallizations (6, 8) contained in said plane zone, the die (23) and the peripheral clamping means (39, 46).

8. Device according to claim 7, characterized in that the peripheral clamping means are integral with a pot (37) and a crown (42); the pot (37) comprises a cavity (38) permitting the creation on one of the faces of the structure to be formed of a hydrostatic counter pressure which is generated by introduction or extraction of a fluid.

9. Device according to any one of claims 7 and 8, characterized in that heat exchange means (32) are provided for heating and cooling the structure which is the object of the shaping.

10. Device according to claim 9, characterized in that said means comprise a heat carrier fluid generator (32) connected to a circulation chamber (28) located in the interior of the die.

11. Device according to any one of claims 7 to 10, characterized in that the face of the die (23) determining the shaping is convex.

12. Device according to any one of claims 7 to 10, characterized in that the face of the die (23) determining the shaping is concave.

13. Device according to any one of claims 7 to 10, characterized in that the face of the die (23) determining the shaping is composed of convex and concave parts.

14. Device according to any one of claims 7 to 13, characterized in that the control of the displacement of the die (23) and that of the peripheral clamping means (39, 46) is a control by jack (20, 47).

# FIG.1

# FIG.2

# FIG. 3

# FIG. 4

# FIG. 5

# FIG. 6

# FIG.7

# FIG. 8